# DEMANDE DE BREVET EUROPEEN

(11) **EP 4 482 269 A1**
(43) Date de publication de la demande: **25.12.2024**
(21) Numéro de dépôt: 23305974.0
(22) Date de dépôt: 20.06.2023
(51) Int. Cl.: H05K 7/20

(54) **PROCÉDÉ DE REMPLACEMENT DU LIQUIDE D'UN CIRCUIT DE REFROIDISSEMENT D'UNE ARMOIRE DE SUPERCALCULATEUR**

(71) Demandeur: BULL SAS, 78340 Les Clayes-Sous-Bois (FR)
(72) Inventeur: HILT, Arnaud, 78610 AUFFARGIS (FR); NADIFI, EIMED, 49240 AVRILLÉ (FR)
(74) Mandataire: Argyma

(57) **Abrégé**

L'invention concerne un procédé de remplacement du liquide d'un circuit de refroidissement liquide d'une armoire de supercalculateur, comprenant une pompe principale et une pompe de réserve, à l'aide d'un groupe de maintenance, comprenant les étrapes de débranchement (E1) de la pompe de réserve, branchement (E2) du réservoir amont à la pompe de réserve, raccordement (E3) du réservoir aval, arrêt (E4) de la pompe principale activation (E5) de la pompe de réserve, arrêt (E6) de la pompe de réserve une fois que le réservoir amont est en-dessous d'un seuil bas prédéterminé, débranchement (E7) du réservoir amont de la pompe de réserve, débranchement (E8) de la pompe de réserve du réservoir aval, branchement (E9) du tuyau d'alimentation d'entrée à la pompe de réserve afin de remettre ladite pompe de réserve dans sa configuration initiale et réactivation (E10) de la pompe principale.

## Description

### [Domaine technique]

La présente invention se rapporte au domaine du refroidissement liquide des supercalculateurs et concerne plus particulièrement un procédé de remplacement du liquide d'un circuit de refroidissement d'une armoire de supercalculateur

### [Etat de la technique antérieure]

Aujourd'hui, de plus en plus de domaines font appel à du calcul haute performance (« High performance computing » en anglais, abrégé en HPC) pour traiter des opérations informatiques.

Les processeurs qui réalisent ces calculs haute performance sont le plus souvent installés dans des armoires (aussi appelés « racks » en anglais) qui peuvent être ellesmêmes rangées dans des centres de calcul.

Ces processeurs peuvent chauffer de manière importante et doivent donc être refroidis pour fonctionner de manière optimale et pour éviter la détérioration de leurs composants. Ainsi, les armoires de supercalculateurs, qui contiennent plusieurs lames de calcul sur lesquelles sont branchés plusieurs processeurs, nécessitent l'utilisation d'un système de refroidissement.

Ce système de refroidissement est le plus souvent monté dans l'armoire et comporte un circuit hydraulique fermé dans lequel un liquide de refroidissement est mis en circulation par une pompe dite « principale ». Afin de prévenir l'arrêt de l'armoire de supercalculateur en cas de défaillance de la pompe principale, une pompe dite « de réserve » est généralement prévue sur le circuit en parallèle de la pompe principale afin de prendre le relais si la pompe principale tombe en panne.

Afin de maintenir l'efficacité du refroidissement, il est nécessaire de changer régulièrement le liquide circulant dans le circuit hydraulique de refroidissement. La solution couramment utilisée consiste à vider manuellement le circuit du liquide de refroidissement usagé en ouvrant le circuit en un point bas via un système de vannes et en laissant le liquide s'écouler par gravité dans un réservoir de récupération. Une fois le circuit vidé, un temps de séchage est observé, puis le circuit est refermé via le système de vannes.

Ensuite, le circuit est relié à un groupe de maintenance comportant un réservoir contenant le liquide de refroidissement neuf et une pompe de maintenance. Une fois le groupe de maintenance relié au circuit de refroidissement de l'armoire, la pompe principale étant toujours à l'arrêt, la pompe de maintenance est activée manuellement afin de faire circuler le liquide de refroidissement neuf et remplir ainsi le circuit.

Cependant, cette solution implique l'arrêt des lames de calcul pendant le temps de séchage du circuit et le temps de remplissage du circuit avec le nouveau liquide. De plus, il est également nécessaire d'attendre le redémarrage complet des lames avant de pouvoir les utiliser à nouveau. Le temps total d'interruption des lames de calcul, qui peut s'avérer important, réduit leur rendement et donc leur efficacité, ce qui présente un inconvénient important.

De plus, la manipulation manuelle des différentes vannes et des pompes de l'armoire peut être source d'éventuelles erreurs qui peuvent endommager les composants.

Il existe donc un besoin pour une solution simple et efficace permettant de remédier au moins en partie à ces inconvénients.

### [Exposé de l'invention]

A cette fin, l'invention a d'abord pour objet un procédé de remplacement du liquide d'un circuit de refroidissement liquide d'une armoire de supercalculateur à l'aide d'un groupe de maintenance, ladite armoire comprenant un circuit de refroidissement liquide, une pompe principale montée dans ledit circuit de refroidissement liquide et une pompe de réserve montée en parallèle de ladite pompe principale par un tuyau d'alimentation d'entrée raccordé en amont de ladite pompe principale et un tuyau d'alimentation de sortie raccordé en aval de ladite pompe principale, ledit groupe de maintenance comprenant un réservoir amont de liquide de refroidissement neuf et un réservoir aval de récupération du liquide de refroidissement usagé, ledit procédé comprenant les étapes de :
- débranchement du tuyau d'alimentation d'entrée de la pompe de réserve,
- branchement du tuyau d'alimentation d'entrée sur le réservoir aval,
- raccordement du réservoir amont à l'entrée de la pompe de réserve via un tuyau dit « de vidange »,
- arrêt de la pompe principale,
- activation de la pompe de réserve afin de faire circuler le liquide de refroidissement du réservoir amont jusqu'au réservoir aval à travers la pompe de réserve,
- arrêt de la pompe de réserve une fois que le liquide de refroidissement neuf du réservoir amont est en-dessous d'un seuil bas prédéterminé,
- débranchement du tuyau de vidange pour déconnecter le réservoir amont de la pompe de réserve,
- débranchement du tuyau d'alimentation d'entrée du réservoir aval,
- branchement du tuyau d'alimentation d'entrée sur l'entrée de la pompe de réserve afin de remettre ladite pompe de réserve dans sa configuration initiale,
- réactivation de la pompe principale.

Ce procédé permet de s'affranchir de la contrainte d'arrêter les composants actifs des lames de calcul de l'armoire supercalculateur, qui peut donc continuer à fonctionner pendant le remplacement du liquide de refroidissement. Ce procédé ne nécessite pas de modification au niveau des armoires de supercalculateurs, puisque le fait qu'elles soient équipées d'une pompe de réserve est connu de l'état de la technique, et peut donc s'adapter sur du matériel existant.

De préférence, les étapes d'arrêt de la pompe principale, d'activation de la pompe de réserve, d'arrêt de la pompe de réserve une fois que le liquide de refroidissement neuf du réservoir amont est en-dessous d'un seuil bas prédéterminé et de réactivation de la pompe principale sont réalisées de manière automatique. Ainsi ces opérations sont moins pénibles à effectuer par l'opérateur et le procédé évite des erreurs de réglages qui peuvent abîmer le circuit de refroidissement liquide.

En variante, les étapes du procédé d'arrêt de la pompe principale, d'activation de la pompe de réserve, d'arrêt de la pompe de réserve une fois que le liquide de refroidissement neuf du réservoir amont est en-dessous d'un seuil bas prédéterminé et de réactivation de la pompe principale sont réalisées manuellement par l'opérateur qui règle une à une chacune des pompes.

De préférence encore, le groupe de maintenance comprend une pompe de maintenance en sortie du réservoir amont, ladite pompe de maintenance étant reliée à la pompe de réserve via le tuyau de vidange, et le procédé comme présenté ci-dessus comprend une étape d'activation de ladite pompe de maintenance, de préférence simultanément à l'activation de la pompe de réserve. Cette étape d'activation de la pompe de maintenance permet de seconder la pompe de réserve afin d'éviter que les pertes de charge dans le circuit de refroidissement liquide soient trop importantes et empêchent la mise en circulation du liquide de refroidissement neuf.

L'invention concerne également un système de vidange de liquide de refroidissement pour supercalculateur, ledit système comprenant :
- une armoire de supercalculateur configurée pour recevoir des lames de calcul et comprenant un circuit de refroidissement liquide, une pompe principale montée dans ledit circuit de refroidissement liquide et une pompe de réserve montée en parallèle de ladite pompe principale,
- un groupe de maintenance amovible comprenant un réservoir amont de liquide de refroidissement neuf et un réservoir aval de récupération du liquide de refroidissement usagé configurés chacun pour être raccordé à l'armoire,
- un module de contrôle configuré pour piloter la pompe principale et la pompe de réserve de l'armoire.

De préférence, le module de contrôle est configuré pour, dans un mode de maintenance automatique, réaliser automatiquement la séquence suivante : commander l'arrêt de la pompe principale puis commander l'activation de la pompe de réserve puis commander l'arrêt de la pompe de réserve une fois que le liquide du réservoir amont est en-dessous d'un seuil bas prédéterminé puis commander la réactivation de la pompe principale.

En variante ou en complément, le mode de maintenance automatique peut être enclenché par un opérateur, par exemple en appuyant sur une touche du module de contrôle.

De préférence, le module de contrôle est configuré pour détecter que le liquide du réservoir amont est en-dessous d'un seuil bas prédéterminé.

De préférence encore, le groupe de maintenance comprend une pompe de maintenance en sortie du réservoir amont, la sortie de ladite pompe de maintenance étant configurée pour être reliée à l'entrée de la pompe de réserve de l'armoire par un tuyau de vidange, le module de contrôle étant configuré pour commander l'activation de ladite pompe de maintenance.

Avantageusement, le module de contrôle est configuré pour commander l'activation de la pompe de réserve et l'activation de pompe de maintenance simultanément.

De préférence, le groupe de maintenance est configuré pour détecter lors d'une vidange que le liquide du réservoir amont est en-dessous d'un seuil bas prédéterminé et indiquer au module de contrôle ou à un opérateur, par exemple visuellement, que le liquide du réservoir amont est en-dessous d'un seuil bas prédéterminé.

De préférence encore, le groupe de maintenance comprend au moins un module de filtration.

De préférence, le module de filtration est monté en entrée du réservoir aval.

Dans une forme de réalisation, le module de contrôle est interne à l'armoire.

Dans une autre forme de réalisation, le module de contrôle est interne au groupe de maintenance.

Dans encore une autre forme de réalisation, le module de contrôle est externe à l'armoire et au groupe de maintenance.

### [Description des dessins]

D'autres caractéristiques et avantages de l'invention apparaîtront encore à la lecture de la description qui va suivre. Celle-ci est purement illustrative et doit être lue en regard des dessins annexés sur lesquels :
[Fig 1] La figure 1 une forme de réalisation du système selon l'invention avant le raccordement du groupe de maintenance à l'armoire.
[Fig 2] La figure 2 illustre schématiquement une forme de réalisation du système selon l'invention après le raccordement du groupe de maintenance à l'armoire.
[Fig 3] La figure 3 illustre schématiquement le système de la figure 2 comprenant en outre une liaison de commande entre l'armoire et le groupe de maintenance.

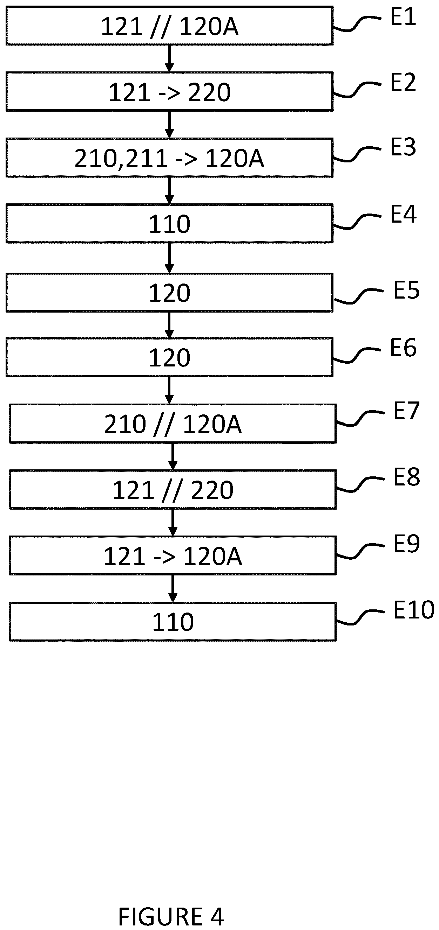

[Fig 4] La figure 4 illustre les étapes du procédé selon l'invention.

### [Description des modes de réalisation]

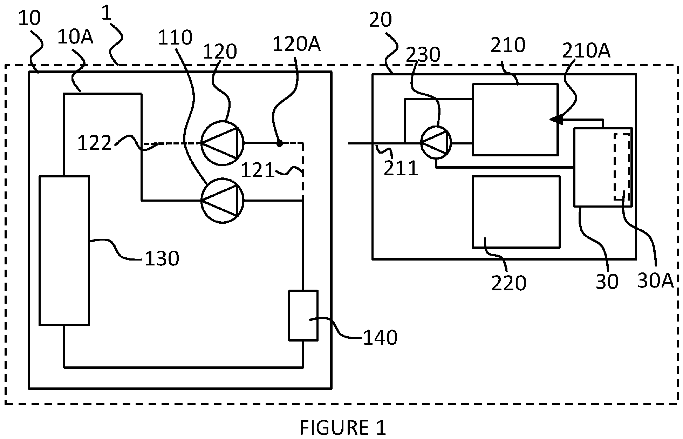

La figure 1 illustre schématiquement un exemple de système 1 selon l'invention.

### Système 1

Le système 1 comprend une armoire 10, un groupe de maintenance 20 et un module de contrôle 30.

### Armoire 10

L'armoire 10 comprend une pluralité de lames de calcul (non représentées), un circuit de refroidissement liquide 10A hydraulique pour le refroidissement des éléments actifs desdites lames de calcul, une pompe principale 110, une pompe de réserve 120, un échangeur de chaleur des lames de calcul 130 et un échangeur de chaleur secondaire 140.

Le circuit de refroidissement liquide 10A relie par des connexions fluidiques la pompe principale 110, l'échangeur de chaleur des lames de calcul 130 et l'échangeur de chaleur secondaire 140.

La pompe principale 110 assure la circulation du liquide de refroidissement dans le circuit de refroidissement liquide 10A.

La pompe de réserve 120 est placée en parallèle de la pompe principale 110 et a pour fonction de se substituer à la pompe principale 110 en cas de panne de cette dernière pour assurer la circulation dans le circuit de refroidissement liquide 10A.

La pompe de réserve 120 a un orifice d'entrée 120A. Un tuyau d'alimentation d'entrée 121 est branché à cet orifice d'entrée 120A et est raccordé au circuit de refroidissement liquide 10A en amont de la pompe principale 110.

Un tuyau d'alimentation de sortie est branché sur la pompe de réserve 120 et est raccordé au circuit de refroidissement liquide 10A en aval de la pompe principale 110.

L'échangeur de chaleur des lames de calcul 130 permet le refroidissement des éléments actifs des lames de calcul (non représentés sur les figures) par le liquide de refroidissement en circulation dans le circuit de refroidissement liquide 10A.

L'échangeur de chaleur secondaire 140 permet le refroidissement du liquide de refroidissement après le passage dans l'échangeur de chaleur des lames de calcul 130 pour conserver la fonction de refroidissement du circuit de refroidissement liquide 10A.

L'armoire 10 peut être réglée manuellement en mode de maintenance, dans lequel la pompe principale 110 est mise à l'arrêt et la pompe de réserve 120 est mise en marche.

### Groupe de maintenance 20

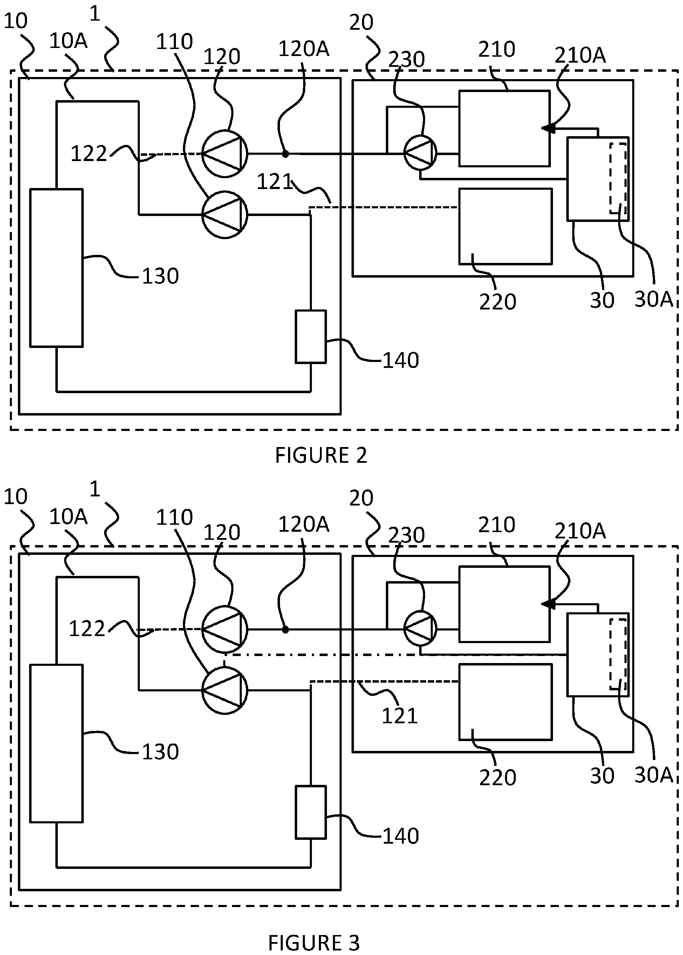

En référence à la figure 2, le groupe de maintenance 20 est relié à l'armoire 10 pour effectuer les étapes du procédé selon l'invention.

Le groupe de maintenance 20 comprend un réservoir amont 210 de liquide de refroidissement neuf, un réservoir aval 220 de récupération du liquide de refroidissement usagé, et une pompe maintenance 230.

Le réservoir amont 210 contient le liquide de refroidissement neuf qui est destiné à remplacer le liquide usagé du circuit de refroidissement liquide 10A. Le réservoir amont 210 comprend un capteur de niveau de liquide 210A qui est électriquement relié au module de contrôle 30 ou communiquant avec le module de contrôle 30.

Un tuyau de vidange 211 est branché sur le réservoir amont 210 et permet au liquide de refroidissement neuf de circuler vers le circuit de refroidissement liquide 10A lors de l'opération de remplacement du liquide de refroidissement.

Lorsque le groupe de maintenance 20 est relié à l'armoire 10, le tuyau de vidange 211 est branché à l'orifice d'entrée 120A de la pompe de réserve 120.

Le réservoir aval 220 sert à récupérer le liquide de refroidissement usagé du circuit de refroidissement liquide 10A au cours du procédé.

La pompe de maintenance 230 est située sur une sortie du réservoir amont 210 différente de celle sur laquelle le tuyau de vidange 221 est branché, et est raccordée audit tuyau de vidange 211 à une certaine distance du réservoir amont 210.

La pompe de réserve 120 est reliée au module de contrôle 30.

La pompe de maintenance 230 permet d'augmenter le débit de circulation du liquide de refroidissement neuf et d'éviter que les pertes de charge induites par les différents éléments du circuit de refroidissement liquide 10A soient trop importantes et empêchent l'injection du liquide de refroidissement neuf.

En variante, la pompe de maintenance 230 peut ne pas être présente sur le circuit.

En variante encore, le tuyau de vidange 211 peut être directement branché à la sortie de la pompe de maintenance 230.

### Module de contrôle 30

Le module de contrôle 30 permet à un opérateur de piloter le groupe de maintenance 20. Il comprend une interface de pilotage 30A, permet de choisir un mode de fonctionnement pour le procédé et permet de piloter la pompe de maintenance 230.

De préférence, le module de contrôle 30 est situé dans le groupe de maintenance 20.

Avantageusement, le module de contrôle 30 peut être relié à l'armoire 10 pour piloter la pompe principale 110 et la pompe de réserve 120 comme représenté sur la figure 3.

En variante, le module de contrôle 30 peut être placé soit dans l'armoire 10, soit être placé de façon autonome à l'extérieur de l'armoire 10 et du groupe de maintenance 20.

### Exemple de mise en oeuvre

De préférence, le groupe de maintenance 20 est amovible et déplaçable.

En préalable du déclenchement du procédé, le groupe de maintenance 20 est donc déplacé à proximité de l'armoire 10 dont le liquide de refroidissement du circuit de refroidissement liquide 10A doit être changé. Les composants actifs des lames de calcul contenues dans l'armoire 10 sont en marche.

Dans l'étape E1, le tuyau d'alimentation d'entrée 121 de la pompe de réserve 120 est débranché.

Dans l'étape E2, le tuyau de vidange 211 du réservoir amont 210 du groupe de maintenance 20 est raccordé à l'orifice d'entrée 120A de la pompe de réserve 120.

Dans l'étape E3, le tuyau d'alimentation d'entrée 121 de la pompe de réserve 120 débranché à l'étape E1 est raccordé au réservoir aval 220 du groupe de maintenance 20.

A la suite de l'étape E3, l'ensemble 1 formé par l'armoire 10 et le groupe de maintenance 20 est représenté sur la figure 2.

Une fois que le groupe de maintenance 20 est relié à l'armoire 10, l'étape E4 est l'arrêt de la pompe principale 110.

L'étape E5 est l'activation de la pompe de réserve 120. Une fois cette étape accomplie, la pompe de réserve 120 aspire dans le circuit de refroidissement liquide 10A le liquide de refroidissement neuf contenu dans le réservoir amont 210 par le tuyau de vidange 211 et le liquide de refroidissement usagé s'écoule dans le réservoir aval 220 par le tuyau d'alimentation d'entrée 121.

De préférence, les étapes E4 et E5 sont mises en oeuvre automatiquement via l'activation par l'opérateur d'un mode de maintenance sur l'armoire 10.

De préférence encore, la pompe de maintenance 230 est aussi activée pendant ou après l'étape E5 pour contrebalancer les pertes de charge dans l'écoulement du liquide de refroidissement neuf. La pompe de maintenance 230 est déclenchée par l'opérateur à partir du module de contrôle 30 du groupe de maintenance 20.

Dans un premier mode de fonctionnement, le module de contrôle 30 permet à l'opérateur de régler le débit de la pompe de maintenance 230 via son interface de pilotage 30A. Le débit de la pompe principale 110 et de la pompe de réserve 120 sont pilotés par le mode de maintenance de l'armoire 10.

Dans un deuxième mode de fonctionnement, le module de contrôle 30 permet à l'opérateur de choisir un programme qui pilote de façon automatique le réglage de la pompe de maintenance 230 via son interface de pilotage 30A. Le débit de la pompe principale 110 et de la pompe de réserve 120 sont pilotés par le mode de maintenance de l'armoire 10.

En variante, le réglage de la pompe principale 110, de la pompe de réserve 120 et de la pompe de maintenance 230 peut être effectué de façon manuelle par l'opérateur.

L'étape E5 se termine lorsque le liquide de refroidissement neuf contenu dans le réservoir amont 210 est en-dessous d'un seuil bas prédéterminé, et que tout le liquide de refroidissement du circuit de refroidissement liquide 10A a été changé.

De préférence, le réservoir amont 210 est muni d'un capteur de niveau de liquide 210A relié au ou communiquant avec le module de contrôle 30 du groupe de maintenance 20. Ce capteur de niveau de liquide 210A envoie l'information que le liquide de refroidissement neuf contenu dans le réservoir amont 210 est en-dessous d'un seuil bas prédéterminé et le module de contrôle 30 déclenche l'étape suivante E6.

En variante ou en complément, le réservoir amont 210 a une paroi transparente graduée qui permet un contrôle visuel du niveau de liquide de refroidissement par l'opérateur.

Dans une étape E6, la pompe de réserve 120 est arrêtée une fois que le liquide de refroidissement neuf contenu dans le réservoir amont 210 est en-dessous d'un seuil bas prédéterminé.

Dans une étape E7, le tuyau de vidange 211 du réservoir amont 210 est débranché de l'orifice d'entrée 120A de la pompe de réserve 120.

Dans une étape E8, le tuyau d'alimentation d'entrée 121 de la pompe de réserve 120 est débranché du réservoir aval 220.

En variante, l'ordre des étapes E7 et E8 peut être permuté.

Dans une étape E9, le tuyau d'alimentation d'entrée 121 est rebranché sur l'orifice d'entrée 120A de la pompe de réserve 120.

Dans une étape E10, la pompe principale 110 est réactivée et le liquide re refroidissement neuf circule dans le circuit de refroidissement liquide 10A.

De préférence, les étapes E6 et E10 sont mises en oeuvre automatiquement par l'activation par l'opérateur d'un mode de maintenance sur l'armoire 10.

En variante, l'étape E10 peut être effectuée entre les étapes E6 et E7.

Les composants actifs des lames de calcul contenus dans l'armoire 10 n'ont pas eu besoin d'être arrêtés lors du remplacement du liquide de refroidissement puisque l'alternance du fonctionnement de la pompe principale 110 et de la pompe de réserve 120 a permis de maintenir une circulation de liquide de refroidissement dans l'échangeur de chaleur des lames de calcul 130.

A l'issue du procédé, le liquide de refroidissement du circuit de refroidissement liquide 10A a été changé et l'armoire 10 et le groupe de maintenance 20 ne sont plus reliés fluidiquement. Le groupe de maintenance 20 peut être alors déplacé pour vider le liquide de refroidissement usagé qui a été récupéré lors du procédé et pour remplir le réservoir amont 210 de liquide de refroidissement neuf en vue d'une autre opération de remplacement du liquide de refroidissement.

Dans une variante, le procédé comprend à l'étape E5 une réactivation temporaire de la pompe principale 110 lors de l'aspiration du liquide de refroidissement neuf dans le circuit de refroidissement liquide 10A afin de purger le liquide de refroidissement usagé qui est piégé dans la pompe principale 110 et le remplacer par du liquide de refroidissement neuf.

## Revendications

1. Procédé de remplacement du liquide d'un circuit de refroidissement liquide (10A) d'une armoire (10) de supercalculateur à l'aide d'un groupe de maintenance (20), ladite armoire (10) comprenant un circuit de refroidissement liquide (10A), une pompe principale (110) montée dans ledit circuit de refroidissement liquide (10A) et une pompe de réserve (120) montée en parallèle de ladite pompe principale (110) par un tuyau d'alimentation d'entrée (121) raccordé en amont de ladite pompe principale (110) et un tuyau d'alimentation de sortie (122) raccordé en aval de ladite pompe principale (110), ledit groupe de maintenance (20) comprenant un réservoir amont (210) de liquide de refroidissement neuf et un réservoir aval (220) de récupération du liquide de refroidissement usagé, ledit procédé comprenant les étapes de :
- débranchement (E1) du tuyau d'alimentation d'entrée (121) de la pompe de réserve (120),
- branchement (E2) du tuyau d'alimentation d'entrée (121) au réservoir aval (220),
- raccordement (E3) du réservoir amont (210) à l'entrée de la pompe de réserve (120) via un tuyau dit « de vidange » (211),
- arrêt (E4) de la pompe principale (110),
- activation (E5) de la pompe de réserve (120) afin de faire circuler le liquide de refroidissement du réservoir amont (210) jusqu'au réservoir aval (220) à travers la pompe de réserve (120),
- arrêt (E6) de la pompe de réserve (120) une fois que le liquide de refroidissement neuf du réservoir amont (210) est en-dessous d'un seuil bas prédéterminé,
- débranchement (E7) du tuyau de vidange (211) pour déconnecter le réservoir amont (210) de la pompe de réserve (120),
- débranchement (E8) du tuyau d'alimentation d'entrée (121) du réservoir aval (220),
- branchement (E9) du tuyau d'alimentation d'entrée (121) sur l'entrée de la pompe de réserve (120) afin de remettre ladite pompe de réserve (120) dans sa configuration initiale,
- réactivation (E10) de la pompe principale (110).

2. Procédé selon la revendication 1, dans lequel les étapes d'arrêt (E4) de la pompe principale (110), d'activation (E5) de la pompe de réserve (120), d'arrêt (E6) de la pompe de réserve (120) une fois que le réservoir amont (210) est en-dessous du seuil bas prédéterminé et de réactivation (E10) de la pompe principale (110) sont réalisées de manière automatique.

3. Procédé selon l'une quelconque des revendications 1 ou 2, dans lequel, le groupe de maintenance (20) comprenant une pompe de maintenance (230) en sortie du réservoir amont (210), ladite pompe de maintenance (230) étant reliée à la pompe de réserve (120) via le tuyau de vidange, le procédé comprend une étape d'activation de ladite pompe de maintenance (230), de préférence simultanément à l'activation de la pompe de réserve (120).

4. Système (1) de vidange de liquide de refroidissement pour supercalculateur, ledit système (1) comprenant :
- une armoire (10) de supercalculateur configurée pour recevoir des lames de calcul et comprenant un circuit de refroidissement liquide (10A), une pompe principale (110) montée dans ledit circuit de refroidissement liquide (10A) et une pompe de réserve (120) montée en parallèle de ladite pompe principale (110),
- un groupe de maintenance (20) amovible comprenant un réservoir amont (210) de liquide de refroidissement neuf et un réservoir aval (220) de récupération du liquide de refroidissement usagé configurés chacun pour être raccordé à l'armoire (10),
- un module de contrôle (30) configuré pour piloter la pompe principale (110) et la pompe de réserve (120) de l'armoire (10).

5. Système (1) selon la revendication précédente, dans lequel le module de contrôle (30) est configuré pour, dans un mode de maintenance automatique, réaliser automatiquement la séquence suivante : commander l'arrêt de la pompe principale (110) puis commander l'activation de la pompe de réserve (120) puis commander l'arrêt de la pompe de réserve (120) une fois que le liquide du réservoir amont (210) est en-dessous d'un seuil bas prédéterminé puis commander la réactivation de la pompe principale (110).

6. Système (1) selon la revendication précédente, dans lequel le mode de maintenance automatique est enclenché par un opérateur, par exemple en appuyant sur une touche du module de contrôle (30).

7. Système (1) selon l'une quelconque des revendications 4 à 6, dans lequel le module de contrôle (30) est configuré pour détecter que le liquide du réservoir amont (210) est en-dessous d'un seuil bas prédéterminé.

8. Système (1) selon l'une quelconque des revendications 4 à 7, dans lequel le groupe de maintenance (20) comprend une pompe de maintenance (230) en sortie du réservoir amont (210), la sortie de ladite pompe de maintenance (230) étant configurée pour être reliée à l'entrée de la pompe de réserve (120) de l'armoire (10) par un tuyau de vidange, le module de contrôle (30) étant configuré pour commander l'activation de ladite pompe de maintenance (230).

9. Système (1) selon la revendication précédente, dans lequel le module de contrôle (30) est configuré pour commander l'activation de la pompe de réserve (120) et l'activation de pompe de maintenance (230) simultanément.

10. Système (1) selon l'une quelconque des revendications 4 à 9, dans lequel le groupe de maintenance (20) est configuré pour détecter lors d'une vidange que le réservoir amont (210) de liquide de refroidissement neuf est en-dessous d'un seuil bas prédéterminé et indiquer au module de contrôle (30) ou à un opérateur, par exemple visuellement, que le liquide du réservoir amont (210) est en-dessous d'un seuil bas prédéterminé.

11. Système (1) selon l'une quelconque des revendications 4 à 10, dans lequel le groupe de maintenance (20) comprend au moins un module de filtration.

12. Système (1) selon la revendication précédente, dans lequel le module de filtration est monté en entrée du réservoir aval (220).

13. Système (1) selon l'une quelconque des revendications 4 à 12, dans lequel le module de contrôle (28) est interne à l'armoire (10).

14. Système (1) selon l'une quelconque des revendications 4 à 13, dans lequel le module de contrôle (28) est interne au groupe de maintenance (20).

15. Système (1) selon l'une quelconque des revendications 4 à 14, dans lequel le module de contrôle (30) est externe à l'armoire (10) et au groupe de maintenance (20).
